# EUROPÄISCHE PATENTSCHRIFT

(11) **EP 2 780 929 B1**
(45) Veröffentlichungstag und Bekanntmachung des Hinweises auf die Patenterteilung: **10.01.2018**
(21) Anmeldenummer: 12795366.9
(22) Anmeldetag: 09.11.2012
(51) Int. Cl.: H01J 37/34

(54) **ANORDNUNG ZUR EINSPEISUNG VON HF-STROM FÜR ROHRKATHODEN**
ASSEMBLY FOR FEEDING IN HF CURRENT FOR TUBULAR CATHODES
SYSTÈME D'ALIMENTATION EN COURANT HF POUR CATHODES TUBULAIRES

(30) Priorität: 10.11.2011 DE 102011086111
(43) Veröffentlichungstag der Anmeldung: 24.09.2014
(73) Patentinhaber: FHR Anlagenbau GmbH, 01458 Ottendorf-Okrilla (DE)
(72) Erfinder: GAWER, Olaf, 01328 Dresden (DE); KREHER, Sascha, 01465 Dresden (DE)
(74) Vertreter: Lippert Stachow Patentanwälte Rechtsanwälte
(86) Internationale Anmeldenummer: PCT/EP2012/072235
(87) Internationale Veröffentlichungsnummer: WO 2013/068524

(56) Entgegenhaltungen:
- DE-U1-202006 005 011
- US-A1- 2004 140 208
- US-A1- 2008 012 460
- US-A1- 2010 206 718
- US-B1- 6 692 619
- CHAO LIU ET AL: "Coupling study of a rotary Capacitive Power Transfer system", INDUSTRIAL TECHNOLOGY, 2009. ICIT 2009. IEEE INTERNATIONAL CONFERENCE ON, IEEE, PISCATAWAY, NJ, USA, 10 February 2009 (2009-02-10), pages 1-6, XP031456850, ISBN: 978-1-4244-3506-7

## Beschreibung

Die Erfindung betrifft eine Anordnung zur Einspeisung von HF-Strom für drehbare Rohrkathoden in einer Vakuumkammer einer Plasma-Beschichtungsanlage, sowie einer Hochfrequenz-Stromquelle und einer innerhalb der Rohrkathode befindlichen ortsfesten und sich längs derselben ersteckenden Magnetanordnung zur Ausbildung eines Magnetfeldes.

Drehbare Rohrkathoden bestehen gewöhnlich aus einem Stützrohr und einem dieses umgebenden Targetmantel und werden in Plasma-Beschichtungsanlagen zum Beschichten zumeist großflächiger Substrate in einer Vakuumkammer eingesetzt. Die Substrate, z.B. Platten, Tafeln oder breite Metall- oder Kunststoffbänder bzw. Folien werden während des Beschichtungsvorganges in der Vakuumkammer unter der Rohrkathode in einem vorgegebenen Abstand vorbeibewegt. Die Länge solcher Rohrkathoden kann somit durchaus mehrere Meter betragen. Die für das Zünden eines Plasmas zwischen der Rohrkathode und einer Anode (Substrat) notwendige HF-Stromzuführung zur Rohrkathode erfolgt über Kommutatorsysteme mit Kohlebürsten, oder anderen Schleifkontakten und zwar außerhalb, oder innerhalb der Vakuumkammer. Weiterhin befindet sich in der Rohrkathode eine sich über deren gesamten Länge erstreckende und ortsfest angeordnete Magnetanordnung, die sich somit nicht mit der Rohrkathode dreht.

So zeigt die DE 20 2002 005 011 U1 eine solche Stromzuführung für eine Rohrkathode außerhalb der Vakuumkammer, die sich durch eine vakuumdichte Drehdurchführung in die Vakuumkammer erstreckt. Die Rohrkathode ist lediglich einseitig gelagert und zwar auf der Seite der Drehdurchführung. Von Nachteil ist hier, dass die Vakuumdurchführung bei der Einspeisung von HF-Strom durch entstehende Wirbelströme thermisch besonders belastet wird und somit auf Dauer undicht werden kann.

Längere Rohrkathoden müssen außerdem an beiden Enden gelagert bzw. abgestützt werden (DE 10 2006 017 455 A1), um über deren gesamten Länge einen gleichmäßigen Abstand zum Substrat zu gewährleisten.

Aus der US 2002 0189 939 A1 geht eine Wechselstromzuführung für Rohrkathoden über Kohlebürsten hervor, die sich innerhalb der Vakuumkammer befindet. Problematisch ist hier jedoch, dass der von den Kohlebürsten herrührende Abrieb das Vakuum verunreinigen kann, so dass die Vakuumkammer regelmäßig, oder auch während des Sputtervorganges, gereinigt werden muss.

Bei beiden Ausführungsformen tritt jedoch bei der Einspeisung von HF-Strom das Problem auf, dass sich der Strom hauptsächlich durch Oberflächenleitung auf der Oberfläche der Rohrkathode ausbreitet, jedoch durchaus mit örtlich unterschiedlicher Stromdichte. So ist die Stromdichte in der Nähe der Einspeisungsstelle besonders hoch, wohingegen am anderen Ende der Rohrkathode eine geringere Stromdichte zu verzeichnen ist. Die Folge ist ein inhomogener Sputterabtrag.

Darüber hinaus sind Kommutatorsysteme mit Kohlebürsten nur bedingt für die Realisierung einer HF-Einspeisung geeignet.

In der WO 2004/140 208 A1 wird die Einspeisung von HF-Energie in Rohrkathoden beschrieben. Das erfolgt mit Bürsten aus Graphit oder Carbon, die federbelastet außerhalb der Vakuumkammer mit Antriebswellen für die Rohrkathoden in Kontakt stehen.

Weiterhin wird in der US 6 692 619 B1 ein unbeweglich in einer Vakuumkammer montiertes Sputtertarget beschrieben, das mit einer HF-Stromquelle verbunden ist. Zum Auskoppeln des Gleichstromanteils der HF-Stromquelle ist ein serieller Kondensator zwischen der HF-Stromquelle und dem Sputtertarget angeordnet. Zur Stromdurchführung zum Sputtertarget ist der Kondensator durch eine übliche elektrische Verbindung an dieses angeschlossen.

Aus der US 2006/0012460 A1 geht eine Anordnung mit einer drehbaren Rohrkathode hervor, die über eine Bürstenanordnung mit Strom versorgt wird. Die Bürstenanordnung ist außerhalb der Vakuumkammer angeordnet und besteht aus einer Vielzahl von Bürsten, welche nebeneinander um eine Antriebswelle für die Rohrkathode angeordnet sind, um die Zuführung von Starkstrom zu ermöglichen.

In der DE 20 2006 005 011 U1 wird ebenfalls eine Stromzuführung zu einer drehbaren Rohrkathode beschrieben. Die Stromzuführung besteht aus einer Kohlebürste, die das Targetträgerrohr in einer Vorvakuumkammer von oben kontaktiert. Die Kohlebürste ist dabei derart positioniert, dass diese das Trägerrohr gerade noch berührt. Der während des Betriebs entstehende Abrieb kann nicht in die Vakuumkammer gelangen und kann einfach während des Betriebs oder während der Betriebspausen abgesaugt werden.

Aus der US 2010/0206 718 A1 geht schließlich eine PVD-Vorrichtung mit einer Magnetanordnung hervor, die in einer Vakuumkammer fest stehend, oder um eine Achse drehbar, montiert sein kann, die senkrecht durch die Vakuumkammer verläuft. Die Energieversorgung erfolgt wie üblich aus einer HF-Quelle über eine Anschlussleitung und ein Anpassnetzwerk. Eine kontaktlose kapazitive Kopplung für Hochfrequenzstrom ist in Chao, L. et al, 2009 IEEE International Conference on Industrial Technology (ICIT), pages 1-6, "Coupling Study of a Rotary Capacitive Power Transfer System" offenbart. Der Erfindung liegt nun die Aufgabe zugrunde, eine Anordnung zur Einspeisung von HF-Strom für Rohrkathoden zu schaffen, die eine gleichmäßige Einspeisung des HF-Stromes ermöglicht, so dass ein besonders homogener Sputterabtrag von der Rohrkathode gewährleistet wird.

Die der Erfindung zugrunde liegende Aufgabe wird bei einer Anordnung der eingangs genannten Art dadurch gelöst, dass die Hochfrequenz-Stromquelle über eine kapazitive HF-Einspeisung in Form eines Koppelkondensators mit der Rohrkathode innerhalb der Vakuumkammer gekoppelt ist, wobei der Koppelkondensator der HF-Einspeisung aus einem Teil der Oberfläche der Rohrkathode und einer Metallplatte oder - folie besteht, die die Rohrkathode wenigstens teilweise in einem vorgegebenen Abstand umschließt.

Um eine maximale Kapazität des Koppelkondensators zu erreichen, erstreckt sich die Metallplatte oder -folie im Wesentlichen über die gesamte freie Länge der Rohrkathode in der Vakuumkammer.

In Fortführung der Erfindung weist die Metallplatte oder -folie die Form eines Halbzylinders auf, der in einem gleichmäßigen vorgegebenen Abstand zur Rohrkathode angeordnet ist.

Der Halbzylinder befindet sich diametral gegenüber der Magnetanordnung in der Rohrkathode. Somit wird einerseits eine maximale Kapazität des Koppelkondensators sichergestellt und andererseits der Sputtervorgang durch den Koppelkondensator nicht behindert.

Der Abstand zwischen der Rohrkathode und der Metallplatte oder -folie, bzw. dem Halbzylinder, beträgt wenige Millimeter und bevorzugt ca. 2 mm.

In einer Ausgestaltung der Erfindung ist der Spalt zwischen der Rohrkathode und der Metallplatte oder -folie einstellbar. Dadurch ist eine Nachführung entsprechend dem abnehmenden Durchmesser des Rohrtargets infolge Verschleißes durch Partikelabtrag möglich, so dass die Kapazität der HF-Einspeisung während der Nutzungsdauer des Rohrtargets weitgehend konstant gehalten werden kann.

Weiterhin ist die HF-Einspeisung rückseitig mit einer Abschirmung durch Dunkelfeldabschirmung versehen.

Zwischen der Rückseite der Metallplatte oder -folie und der Abschirmung befindet sich eine Isolation aus einem Kunststoff mit hinreichender Biegesteifigkeit, die zugleich einen Blindstrom vermindert. Darüber hinaus dient der Isolationswerkstoff der Erhöhung der mechanischen Stabilität der HF-Einspeisung, so dass über deren gesamten Länge und Breite ein gleichmäßiger Abstand zum Rohrtarget gewährleistet wird.

Die Abschirmung ist mit Masse verbunden.

In einer alternativen Ausgestaltung der Erfindung sind HF-Einspeisungen sinngemäß jeweils an den beiden Enden der Rohrkathode vorgesehen.

In einer weiteren alternativen Ausführungsform der Erfindung sind an beiden Enden der Rohrkathode HF-Einspeisungen in Form von metallischen Hülsen vorgesehen.

Der Koppelkondensator der Einspeisung ist Bestandteil des Anpassnetzwerkes der HF-Stromversorgung.

Die Erfindung soll nachfolgend an einem Ausführungsbeispiel näher erläutert werden. In den zugehörigen Zeichnungen zeigen:
- Fig. 1:: eine schematische Stirnansicht der erfindungsgemäßen HF-Einspeisung; und
- Fig. 2:: ein vereinfachtes Ersatzschaltbild der HF-Einspeisung.

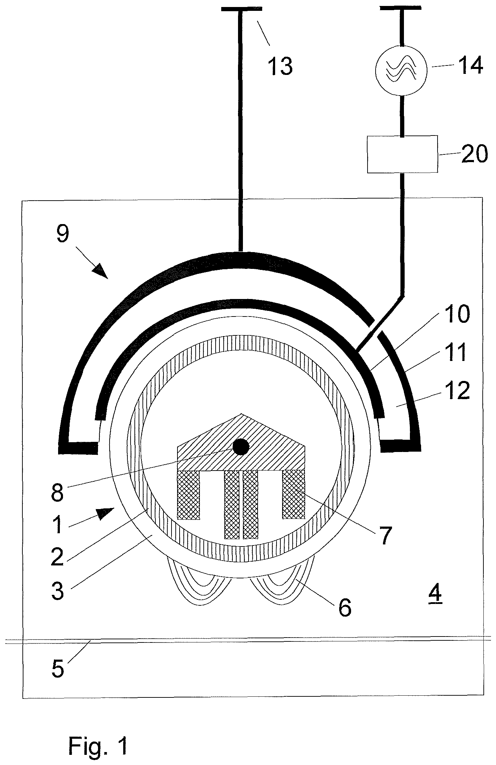

Aus Fig. 1 ist eine Rohrkathode 1, bestehend aus einem Stützrohr 2 und einem Targetmantel 3, in einer Vakuumkammer 4 ersichtlich. Der Targetmantel 3 kann auf das Stützrohr 2 aufgeschoben oder an dieses angegossen, oder anderweitig an diesem befestigt sein. Von diesem Targetmantel 3 wird während des Sputtervorganges Material abgetragen und auf einem unter der Rohrkathode 1 vorbeigeführten Substrat 5, das hier schematisch als Band dargestellt ist, abgeschieden. Dazu muss einerseits ein in der Vakuumkammer 4 ein Plasma gezündet werden, für dessen Zündung beispielsweise ein HF-Strom in die Rohrkathode 1 eingespeist und andererseits ein Magnetfeld 6 erzeugt werden, um das Plasma 6 in Richtung zum Substrat 5 zu konzentrieren. Es versteht sich, dass die Länge der Rohrkathode 1 mindestens der Breite des Substrates 5 entsprechen muss.

Das erforderliche Magnetfeld 6 wird durch eine Magnetanordnung 7 innerhalb der Rohrkathode 1 erzeugt, die sich gegenüber dem Substrat 5 befindet. Damit die Magnetanordnung 7 auch bei sich drehender Rohrkathoden 1 immer ortsfest bleibt, also sich nicht mit dreht, ist diese an einer Drehachse 8, um die sich auch die Rohrkathode 1 dreht, befestigt und hält diese Position der Magnetanordnung 7 auch bei sich drehender Rohrkathode 1 bei.

Die Einspeisung des HF-Stromes in die Rohrkathode 1 erfolgt über eine kapazitive HF-Einspeisung 9, die aus einem Teil der Oberfläche der Rohrkathode 1 und einer Metallplatte oder -folie 10, einen Koppelkondensator 18 bildend, besteht. Die Metallplatte oder -folie 10 weist die Form eines Halbzylinders auf. Diese Metallplatte- oder -folie 10 umschließt die drehbare Rohrkathode 1 etwa zur Hälfte auf der der Magnetanordnung 7 diametral gegenüber liegenden Seite der Rohrkathode 1. Der Abstand zwischen der Metallplatte oder -folie 10 und der Rohrkathode 1 sollte wenige Millimeter, bevorzugt ca. 2 mm, betragen. Die Koppelkapazität des Koppelkondensators 18 der HF-Einspeisung 9 entspricht bei dieser Anordnung der halben Koaxialkapazität.

Bei einer großen Rohrkathode mit leitfähigem Target ergibt sich bei den Ausgangsdaten
Länge der Rohrkathode: 2000 mm
Abstand: 2 mm
Außendurchmesser: 133...140 mm
eine Koppelkapazität der HF-Einspeisung von 3,9 nF. Bei einer L-Schaltung beträgt die Größe der Serienkapazität 16 i.A. 12...500 pF. Damit ergibt sich in der Ersatzschaltung (Serienschaltung von Serienkapazität 16 und Koppelkapazität 18) eine Gesamtausgangskapazität von 12... 443 pF. Die Gesamtkapazität wird damit durch den Abstand zwischen der Metallplatte oder -folie 10 und der Rohrkathode 1 bestimmt.

Ähnliche Werte ergeben sich für nichtleitende Targets im Millimeterbereich mit hoher relativer Permittivität, z.B. Aluminiumoxid.

Um eine maximale Kapazität des zwischen der Metallplatte oder -folie 10 und der Rohrkathode 1 gebildeten Koppelkondensators zu erreichen, sollte sich die Metallplatte oder -folie 10 im Wesentlichen über die gesamte freie Länge der Rohrkathode 1 innerhalb der Vakuumkammer 1 erstrecken.

Durch die Positionierung der HF-Einspeisung 7 zeichnungsgemäß oberhalb der Rohrkathode 1 wird sichergestellt, dass der Sputtervorgang durch die HF-Einspeisung 7 nicht behindert wird.

Weiterhin wird die Metallplatte oder -folie 10 der HF-Einspeisung 9 auf ihrer Rückseite, d.h. auf der von der Rohrkathode 1 abgewandten Seite, von einer Abschirmung 11 durch Dunkelfeldabschirmung umschlossen.

Zwischen der Rückseite der Metallplatte oder -folie 10 und der Abschirmung 11 befindet sich eine Isolation 12, so dass eine Art Sandwichanordnung entsteht, die zugleich einen Blindstrom vermindert. Die Isolation 12 besteht aus einem geeigneten Kunststoff mit genügender mechanischer Stabilität, so dass bei besonders langen HF-Einspeisungen 9 ein Durchhängen derselben weitgehend vermieden werden kann. Das ist notwendig, um über die gesamte Länge der Rohrkathode 1 einen gleichmäßigen Abstand zwischen dem Targetmantel 3 und der Metallplatte öder -folie 10 sicherzustellen und somit eine gleichmäßige Einspeisung des HF-Stromes zu gewährleisten.

Die Abschirmung 11 ist mit Masse 13 verbunden. Darüber hinaus dient die Isolation 12 zwischen der Metallplatte der -folie 10 und der Abschirmung 11 der Erhöhung der mechanischen Stabilität der HF-Einspeisung 7.

Die Metallplatte oder -folie 10 der HF-Einspeisung 9 ist mit einer außerhalb der Vakuumkammer 4 befindlichen HF-Stromquelle 14 über ein Anpassnetzwerk 20 verbunden.

Die vorstehend beschriebene HF-Einspeisung 9 gewährleistet eine hinreichend gleichmäßige, verlustarme Einspeisung des HF-Stromes in die Rohrkathode 1.

Während des Sputtervorganges erfolgt ein stetiger Materialabtrag vom Targetmantel 3, so dass dessen Durchmesser kontinuierlich abnimmt. Das würde wiederum zu einer Verringerung der Kapazität zwischen der Metallplatte oder -folie 10 und der Rohrkathode 1, d.h. dem Targetmantel 3, führen. Die Folge ist ein zunehmender Blindwiderstand für die Einspeisung des HF-Stromes, der nur begrenzt durch das Anpassnetzwerk 20 angepasst werden kann. Um dem entgegen wirken zu können, ist der Spalt zwischen der Rohrkathode 1 und der Metallplatte oder -folie 10 einstellbar. Dadurch kann die HF-Einspeisung 9 entsprechend dem abnehmenden Durchmesser des Targetmantels 3 auf dem Rohrtarget 1 nachgeführt werden. Dazu muss lediglich die Änderung der Einspeiseimpedanz direkt oder indirekt gemessen werden und entsprechend der Abstand zwischen der Metallplatte oder -folie 10 und dem Targetmantel 3 auf z.B. konstant ca. 2 mm gehalten werden.

In einer alternativen Ausgestaltung der Erfindung sind HF-Einspeisungen 9 jeweils an den beiden Enden der Rohrkathode 1 vorgesehen. Dazu sind als Halbzylinder geformte Metallplatten oder -folien 10 vorgesehen, die jeweils wie oben beschrieben mit einer Abschirmung 11 und einer dazwischen befindlichen Isolation 12 versehen sind, in den Endbereichen der Rohrkathode 1 angeordnet. Der größere mittlere Teil der Rohrkathode 1 wird somit nicht teilweise durch eine HF-Einspeisung umfasst, liegt somit frei.

Die Einspeisung des HF-Stromes erfolgt hier ausgehend von den beiden HF-Einspeisungen 9, die auch wie vorstehend beschrieben, entsprechend der Verringerung des Durchmessers des Targetmantels 3 nachgeführt werden können.

Alternativ können auch an beiden Enden der Rohrkathode 1 HF-Einspeisungen in Form von metallischen Hülsen vorgesehen sein, die jeweils mit der HF-Stromquelle 14 verbunden sind. Da in diesem Fall im Bereich der beiden Metallhülsen kein Sputterabtrag vom Targetmantel erfolgen kann, besteht auch keine Notwendigkeit, den Abstand zwischen den Metallhülsen und dem Targetmantel 3 der Rohrkathode 1 verändern zu müssen. Die Kapazität zwischen den Metallhülsen und dem Targetmantel 3 bleibt während der Nutzungsdauer des Targetmantels 3 weitgehend konstant.

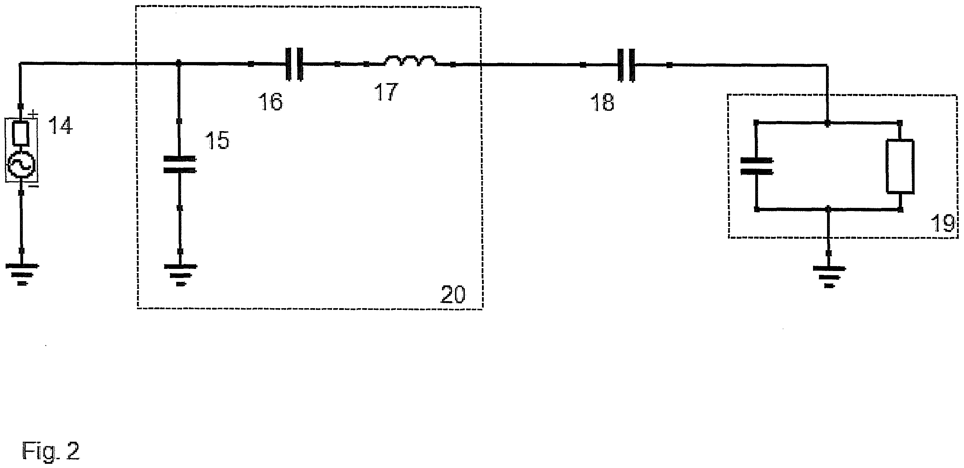

Fig. 2 zeigt ein vereinfachtes Ersatzschaltbild der HF-Einspeisung mit der HF-Stromversorgung 14, dem Anpassnetzwerk 20, bestehend aus einer Serienkapazität 16, einer Parallelkapazität 15 und einer Spule 17, sowie ein schematisches Ersatzschalbild 19 für das Plasma. Der Koppelkondensator 18 der HF-Einspeisung 9 kann auch als Kondensator des Anpassnetzwerkes genutzt werden, diesen ersetzen oder erweitern.

### Bezugszeichenliste

- 1: Rohrkathode
- 2: Stützrohr
- 3: Targetmantel
- 4: Vakuumkammer
- 5: Substrat
- 6: Magnetfeld
- 7: Magnetanordnung
- 8: Drehachse
- 9: HF-Einspeisung
- 10: Metallplatte oder -folie
- 11: Abschirmung
- 12: Isolation
- 13: Masse
- 14: HF-Stromquelle
- 15: Parallelkondensator des Anpassnetzwerkes
- 16: Serienkondensator des Anpassnetzwerkes
- 17: Spule des Anpassnetzwerkes
- 18: Koppelkondensator
- 19: Ersatzschaltbild für das Plasma
- 20: Anpassnetzwerk

## Patentansprüche

1. Anordnung zur Einspeisung von HF-Strom für drehbare Rohrkathoden in einer Vakuumkammer einer Plasma-Beschichtungsanlage, mit einer Hochfrequenz-Stromquelle (14) und einer innerhalb der Rohrkathode (1) befindlichen ortsfesten und sich längs derselben erstreckenden Magnetanordnung (7), **dadurch gekennzeichnet, dass** die HF-Stromquelle (14) über eine kapazitive HF-Einspeisung (9) in Form eines Koppelkondensators (18) mit der Rohrkathode (1) innerhalb der Vakuumkammer (4) gekoppelt ist, wobei der Koppelkondensator (18) der HF-Einspeisung (9) aus einem Teil der Oberfläche der Rohrkathode (1) und einer Metallplatte oder -folie (10) besteht, die die Rohrkathode (1) wenigstens teilweise in einem vorgegebenen Abstand umschließt.

2. Anordnung nach Anspruch 1, **dadurch gekennzeichnet, dass** die Metallplatte oder -folie (10) sich im Wesentlichen über die gesamte freie Länge der Rohrkathode (1) innerhalb der Vakuumkammer (4) erstreckt.

3. Anordnung nach Anspruch 2, **dadurch gekennzeichnet, dass** die Metallplatte oder -folie (10) die Form eines Halbzylinders aufweist, der mit einem gleichmäßigen vorgegebenen Abstand zur Rohrkathode (1) angeordnet ist.

4. Anordnung nach Anspruch 3, **dadurch gekennzeichnet, dass** sich der Halbzylinder diametral gegenüber der Magnetanordnung (7) in der Rohrkathode (1) befindet.

5. Anordnung nach Anspruch 2 bis 4, **dadurch gekennzeichnet, dass** der Abstand zwischen der Rohrkathode (1) und der HF-Einspeisung (9) wenige Millimeter beträgt.

6. Anordnung nach Anspruch 5, **dadurch gekennzeichnet, dass** der Abstand ca. 2 mm beträgt.

7. Anordnung nach einem der Ansprüche 1 bis 6, **dadurch gekennzeichnet, dass** der Abstand zwischen der Rohrkathode (1) und der HF-Einspeisung (9) einstellbar ist.

8. Anordnung nach einem der Ansprüche 1 bis 7, **dadurch gekennzeichnet, dass** die HF-Einspeisung (9) mit einer Abschirmung (11) versehen ist.

9. Anordnung nach Anspruch 8, **dadurch gekennzeichnet, dass** zwischen der HF-Einspeisung (9) und der Abschirmung (11) eine Isolation (12) angeordnet ist.

10. Anordnung nach Anspruch 8 und 9, **dadurch gekennzeichnet, dass** die Abschirmung (11) mit Masse (13) verbunden ist.

11. Anordnung nach einem der Ansprüche 1 bis 10, **dadurch gekennzeichnet, dass** HF-Einspeisungen (9) an beiden Enden der Rohrkathode (1) vorgesehen sind.

12. Anordnung nach einem der Ansprüche 1 und 9 bis 11, **dadurch gekennzeichnet, dass** an beiden Enden der Rohrkathode (1) HF-Einspeisungen in Form von Hülsen vorgesehen sind.

13. Anordnung nach einem der Ansprüche 1 bis 12, **dadurch gekennzeichnet, dass** der Koppelkondensator (18) der HF-Einspeisung Bestandteil des Anpassnetzwerkes der HF-Stromversorgung ist.

## Claims

1. Arrangement for feeding in HF current for rotatable tubular cathodes in a vacuum chamber of a plasma coating system, with a high frequency current source (14) and a stationary magnet arrangement that is located inside the tubular cathode and extends along the same,
**characterized in that** the HF current source (14) is coupled to the tubular cathode (1) inside the vacuum chamber (4) by way of a capacitive HF feed (9) in the form of a coupling capacitor (18), the coupling capacitor (18) of the HF feed (9) consisting of a part of the surface of the tubular cathode (1) and a metal plate or film (10) that surrounds the tubular cathode (1) at least partially at a specified distance.

2. Arrangement according to Claim 1, **characterized in that** the metal plate or film (10) extends substantially over the entire free length of the tubular cathode (1) inside the vacuum chamber (4).

3. Arrangement according to Claim 2, **characterized in that** the metal plate or film (10) has the form of a half-cylinder, which is arranged at a uniform specified distance from the tubular cathode (1).

4. Arrangement according to Claim 3, **characterized in that** the half-cylinder is located diametrically opposite the magnet arrangement (7) in the tubular cathode (1).

5. Arrangement according to Claims 2 to 4, **characterized in that** the distance between the tubular cathode (1) and the HF feed (9) is a few millimetres.

6. Arrangement according to Claim 5, **characterized in that** the distance is about 2 mm.

7. Arrangement according to one of Claims 1 to 6, **characterized in that** the distance between the tubular cathode (1) and the HF feed (9) is adjustable.

8. Arrangement according to one of Claims 1 to 7, **characterized in that** the HF feed (9) is provided with a shielding (11).

9. Arrangement according to Claim 8, **characterized in that** an insulation (12) is arranged between the HF feed (9) and the shielding (11).

10. Arrangement according to Claims 8 and 9, **characterized in that** the shielding (11) is connected to earth (13).

11. Arrangement according to one of Claims 1 to 10, **characterized in that** HF feeds (9) are provided at both ends of the tubular cathode (1).

12. Arrangement according to one of Claims 1 and 9 to 11, **characterized in that** HF feeds are provided at both ends of the tubular cathode (1) in the form of sleeves.

13. Arrangement according to one of Claims 1 to 12, **characterized in that** the coupling capacitor (18) of the HF feed is a component part of the matching network of the HF power supply.

## Revendications

1. Système d'alimentation en courant HF pour cathodes tubulaires pouvant être mises en rotation dans une chambre à vide d'une installation de revêtement au plasma, comportant une source de courant à haute fréquence (14) et un système d'aimants (7) fixe se trouvant à l'intérieur de la cathode tubulaire (1) et s'étendant le long de celle-ci,
**caractérisé en ce que** la source de courant HF (14) est couplée par l'intermédiaire d'une alimentation HF capacitive (9) sous la forme d'un condensateur de couplage (18) à la cathode tubulaire (1) à l'intérieur de la chambre à vide (4), dans lequel le condensateur de couplage (18) de l'alimentation HF (9) est constitué d'une partie de la surface de la cathode tubulaire (1) et d'une plaque ou d'une feuille métallique (10) qui entoure au moins partiellement la cathode tubulaire (1) à une distance prédéterminée.

2. Système selon la revendication 1, **caractérisé en ce que** la plaque ou la feuille métallique (10) s'étend sensiblement sur la totalité de la longueur libre de la cathode tubulaire (1) à l'intérieur de la chambre à vide (4).

3. Système selon la revendication 2, **caractérisé en ce que** la plaque ou la feuille métallique (10) présente la forme d'un demi-cylindre qui est disposé à une distance uniforme prédéterminée de la cathode tubulaire (1).

4. Système selon la revendication 3, **caractérisé en ce que** le demi-cylindre est situé de manière diamétralement opposée au système d'aimants (7) dans la cathode tubulaire (1).

5. Système selon les revendications 2 à 4, **caractérisé en ce que** la distance entre la cathode tubulaire (1) et l'alimentation HF (9) est de quelques millimètres.

6. Système selon la revendication 5, **caractérisé en ce que** la distance est d'environ 2 mm.

7. Système selon l'une quelconque des revendications 1 à 6, **caractérisé en ce que** la distance entre la cathode tubulaire (1) et l'alimentation HF (9) est réglable.

8. Système selon l'une quelconque des revendications 1 à 7, **caractérisé en ce que** l'alimentation HF (9) et munie d'un blindage (11).

9. Système selon la revendication 8, **caractérisé en ce qu'**un isolant (12) est disposé entre l'alimentation HF (9) et le blindage (11).

10. Système selon les revendications 8 et 9, **caractérisé en ce que** le blindage (11) est relié à la masse (13).

11. Système selon l'une quelconque des revendications 1 à 10, **caractérisé en ce qu'**il est prévu des alimentations HF (9) aux deux extrémités de la cathode tubulaire (1).

12. Système selon l'une quelconque des revendications 1 et 9 à 11, **caractérisé en ce qu'**il est prévu des alimentations HF sous forme de manchons aux deux extrémités de la cathode tubulaire (1).

13. Système selon l'une quelconque des revendications 1 à 12, **caractérisé en ce que** le condensateur de couplage (18) de l'alimentation HF fait partie du réseau d'adaptation de l'alimentation en courant HF.
